# EUROPÄISCHE PATENTANMELDUNG

(11) **EP 1 672 698 A1**
(43) Veröffentlichungstag der Anmeldung: **21.06.2006**
(21) Anmeldenummer: 04405775.0
(22) Anmeldetag: 16.12.2004
(51) Int. Cl.: H01L 29/739, H01L 29/08

(54) **Leistungshalbleiter**

(71) Anmelder: ABB Technology AG, 8050 Zürich (CH)
(72) Erfinder: Rahimo, Munaf, 5619 Uezwil (CH); Kopta, Arnost, 8045 Zürich (CH); Linder, Stefan, 4800 Zofingen (CH)
(74) Vertreter: ABB Patent Attorneys

(57) **Zusammenfassung**

Der erfindungsgemässe Leistungshalbleiter (1), insbesondere ein IGBT umfasst eine Driftschicht (2) mit einer Dotierung eines ersten Ladungsträgertyps und eine erste Stoppschicht (3) desselben Ladungsträgertyps wie die Driftschicht (2), wobei die Dotierung der ersten Stoppschicht (3) höher ist als die Dotierung der Driftschicht (2), sowie eine Elektrode (5) eines zweiten Ladungsträgertyps. Zwischen der ersten Stoppschicht (3) und der Elektrode (5) ist eine zweite Stoppschicht (4) des ersten Ladungsträgertyps angeordnet und die zweite Stoppschicht (4) weist eine höhere Dotierung als die erste Stoppschicht (3) auf.

## Beschreibung

### Technisches Gebiet

Die Erfindung bezieht sich auf das Gebiet der Leistungselektronik. Sie bezieht sich auf einen Leistungshalbleiter gemäss Oberbegriff des Patentanspruches 1 sowie ein Verfahren zur Herstellung eines Leistungshalbleiters gemäss Oberbegriff des Patentanspruches 4.

### Stand der Technik

Bei Non-Punch-Through- (NPT-) Insulated Gate Bipolar Transistors (IGBTs), wie sie beispielsweise in der Druckschrift von J. Ymashita et al. (IEEE 1997, S. 109-112) beschrieben sind, grenzt eine niedrig dotierte Driftschicht eines ersten Ladungsträgertyps direkt an die Elektrode eines zweiten Ladungsträgertyps an. Diese IGBTs zeichnen sich dadurch aus, dass im Vergleich zu den im folgenden beschriebenen Punch-Through- (PT-) IGBTs die Driftschicht zur Aufnahme einer hohen Blockierspannung eine grössere Dicke und höhere Dotierung aufweist. Wegen der grösseren Dicke der Driftschicht werden höhere Verluste im IGBT generiert. Im Falle eines Fehlers kann während des Einschaltens des IGBT's ein Kurzschlussstrom mit kurzer Stromspitze auftreten, oder es können Kurzschlussstrompulse während des Betriebs im eingeschalteten Zustand des IGBT's auftreten. In Folge eines solchen Kurzschlussstromes kann der IGBT seine Gatesteuerung verlieren und der Strom kann weiter bis hin zur Zerstörung des IGBT's steigen. Bei NPT-IGBTs ist vorteilhaft, dass die Elektroden-Injektionseffizienz niedrig gehalten werden kann, ohne dass die Robustheit des IGBT's unter Kurzschluss-Bedingungen negativ beeinflusst wird.

Bei Punch-Through- (PT-) IGBTs wird zwischen der Driftschicht und der Elektrode eine hochdotierte Stoppschicht des ersten Ladungsträgertyps eingeführt, wodurch es möglich wird, im Vergleich zu NPT-IGBTs bei denselben Blockierspannungen dünnere Driftschichten zu verwenden. Der Widerstand wird dadurch verringert und beim eingeschalteten IGBT ebenso wie beim Schalten des IGBTs treten geringere Verluste auf. Allerdings ist die Robustheit der PT-IGBT's unter Kurzschlussbedingungen schlechter als bei den NPT-IGBTs.

Um die Vorteile der PT-IGBTs mit denen der NPT-IGBTs zu verbinden, sind Soft-Punch-Through- (SPT-) IGBTs entwickelt worden, deren Stoppschicht zwar höher dotiert ist als die Driftschicht, aber niedriger dotiert als die Stoppschicht eines PT-IGBT's. Die Stoppschicht wird erzeugt, indem Teilchen des ersten Ladungsträgertyps tief in eine Schicht desselben Ladungsträgertyps eindiffundiert werden. Derart erzeugte Stoppschichten weisen eine Dicke von 5 - 60 µm auf. Um die Teilchen tief in die Schicht einzutreiben, sind lange Diffusionszeiten erforderlich. Dadurch werden Defekte in der Schicht erzeugt, welche die Blockierspannung erheblich reduzieren können.

### Darstellung der Erfindung

Aufgabe der Erfindung ist es, einen Leistungshalbleiter, vorzugsweise einen IGBT, anzugeben, der eine höhere Robustheit unter Kurzschlussbedingungen (verbesserte "Short circuit safe operating area", kurz: SCSOA) bei gleichzeitig reduzierten Verlusten und Leckströmen aufweist.

Dies wird erreicht durch eine erste, tiefe und niedrig dotierte Stoppschicht eines ersten Ladungsträgertyps und die Einführung einer zweiten Stoppschicht des ersten Ladungsträgertyps, deren Dotierung höher liegt als diejenige der ersten Stoppschicht und die zwischen der ersten Stoppschicht und der Elektrode eingebettet ist. In der ersten Stoppschicht wird das elektrische Feld abgebaut. Die zweite Stoppschicht bewirkt eine Reduzierung von Leck-Strömen.

Weiterhin ist es Aufgabe der Erfindung, ein Verfahren zur Herstellung eines Leistungshalbleiters mit verbesserter SCSOA bei gleichzeitig reduzierten Verlusten, Leckströmen und Defekten anzugeben.

Weitere vorteilhafte Ausgestaltungen der Erfindung sind in den Unteransprüchen angegeben.

### Kurze Beschreibung der Zeichnungen

Im folgenden wird das erfindungsgemässe Verfahren und der Erfindungsgegenstand anhand von bevorzugten Ausführungsbeispielen, welche in den beiliegenden Zeichnungen dargestellt ist, näher erläutert. Es zeigen:
- FIG 1: Schnitt durch einen erfindungsgemässen Leistungshalbleiter
- FIG 2 bis 9:: Verfahrensschritte zur Herstellung des Leistungshalbleiters nach FIG 1 vom Ausgangsmaterial bis zu einem Stadium, in dem eine Driftschicht mit einer ersten und einer zweiten Stoppschicht verbunden ist unter Verwendung folgender Verfahren:

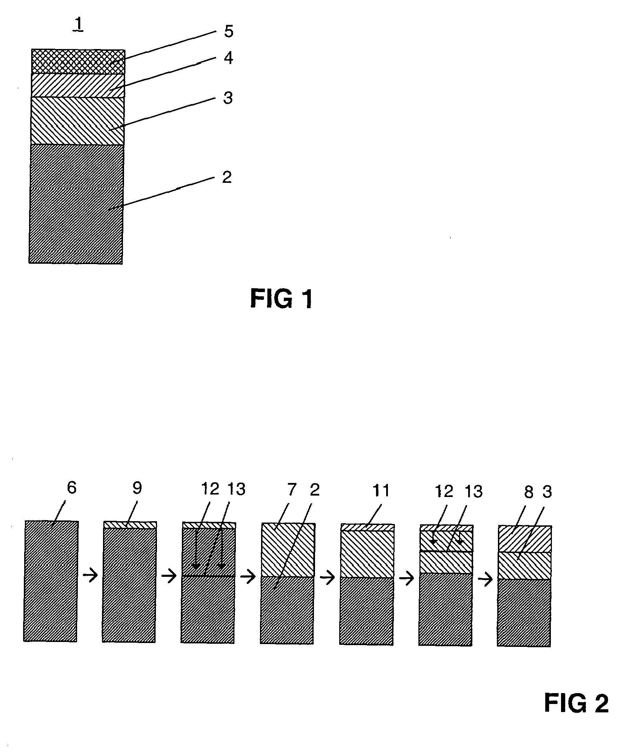

- FIG 2: Diffusionsverfahren;

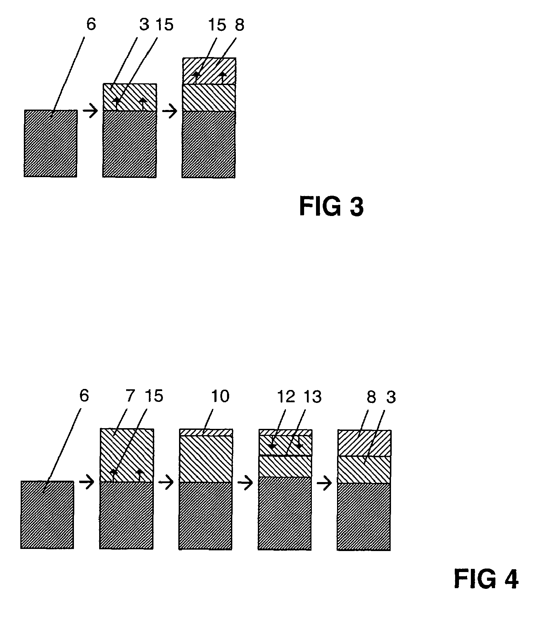

- FIG 3: epitaktisches Wachsen;
- FIG 4: epitaktisches Wachsen, kombiniert mit Diffusionsverfahren;

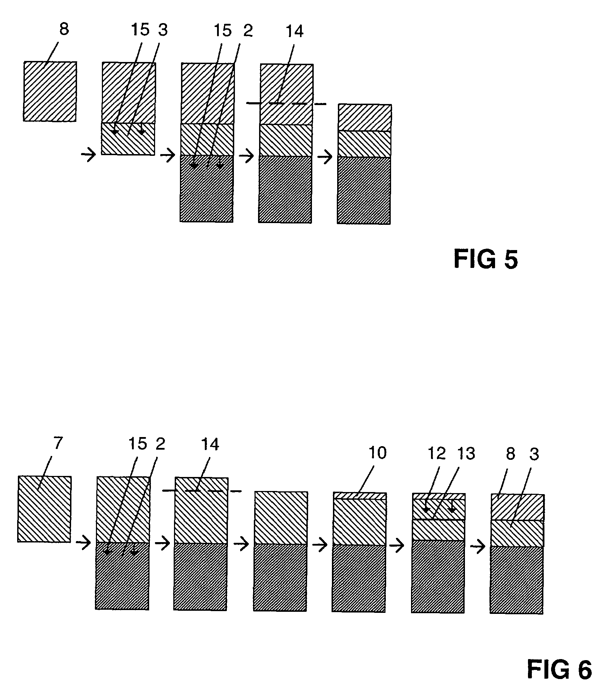

- FIG 5: epitaktisches Wachsen, kombiniert mit Schneiden;
- FIG 6: epitaktisches Wachsen, kombiniert mit Diffusionsverfahren und Schneiden;

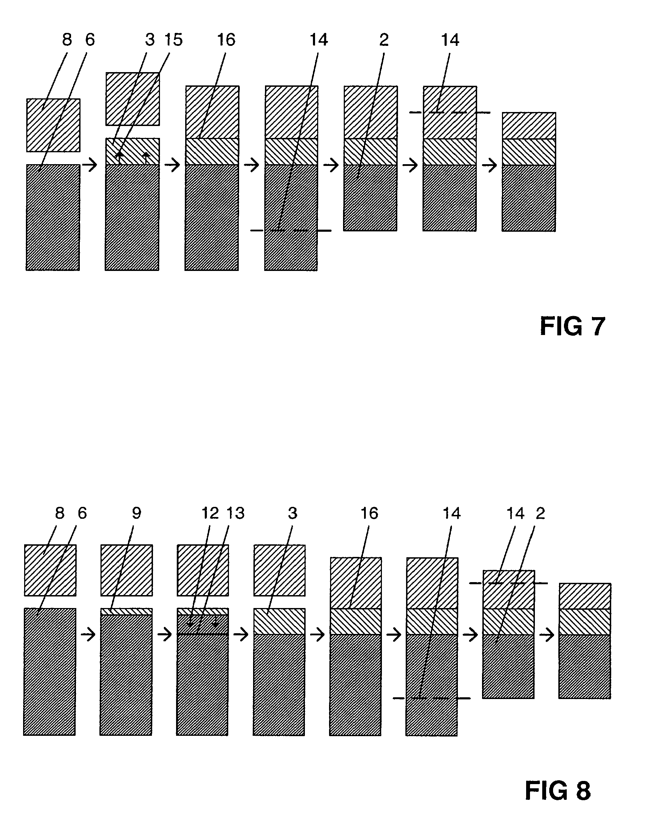

- FIG 7: epitaktisches Wachsen, kombiniert mit Bonding und Schneiden;
- FIG 8: Diffusionsverfahren, kombiniert mit Bonding und Schneiden;

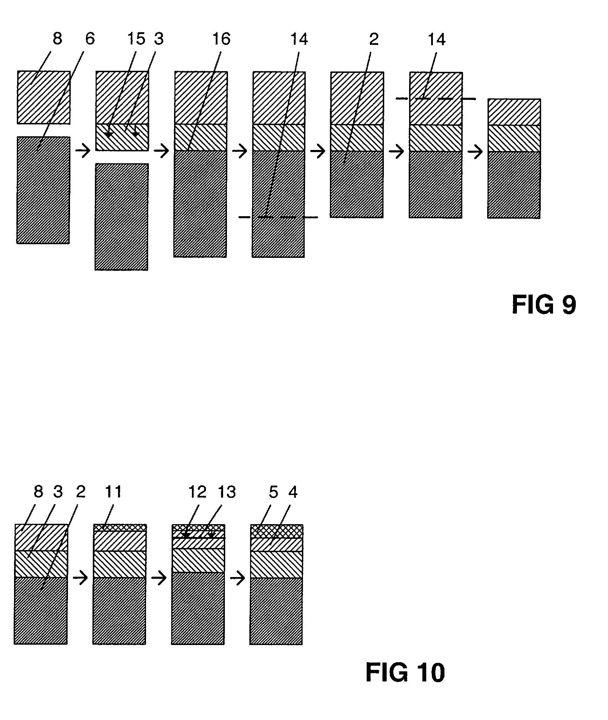

- FIG 9: epitaktisches Wachsen, kombiniert mit Bonding und Schneiden;
- FIG 10: Verfahrensschritte zur Herstellung des Leistungshalbleiters nach FIG 1 vom Endstadium gemäss einer der Figuren FIG 2 bis 9 bis zu dem Stadium, in dem die Elektrode zusätzlich eingebracht wird.

### Wege zur Ausführung der Erfindung

Der in FIG 1 dargestellte erfindungsgemässe Leistungshalbleiter 1 umfasst eine dotierte Driftschicht 2 eines ersten Ladungsträgertyps, auf der eine erste Stoppschicht 3 des ersten Ladungsträgertyps mit einer höheren Dotierung angeordnet ist. Auf der ersten Stoppschicht ist eine zweite Stoppschicht 4 des ersten Ladungsträgertyps, die höher dotiert ist als die erste Stoppschicht 3, angeordnet. An die zweite Stoppschicht grenzt eine Elektrode 5 eines zweiten Ladungsträgertyps an. Im folgenden wird die Driftschicht 2 als niedrig dotiert bezeichnet, was so zu verstehen ist, dass die Driftschicht niedriger als die erste Stoppschicht 3 und die zweite Stoppschicht 4 dotiert ist. Die erste Stoppschicht 3 wird als mittel-dotiert bezeichnet, was so zu verstehen ist, dass die erste Stoppschicht 3 höher als die Driftschicht 2 dotiert ist, aber niedriger dotiert ist als die zweite Stoppschicht 4. Die zweite Stoppschicht 4 wird als hoch dotiert bezeichnet, was so zu verstehen ist, dass die zweite Stoppschicht 4 höher als die Driftschicht 2 und die erste Stoppschicht 3 dotiert ist.

Die Driftschicht 2 weist für Anwendung bei hohen Blockierspannungen, unter denen im folgenden Spannungen, welche höher als 2000 V sind, zu verstehen sind, typischerweise eine Dicke von mehr als 150 µm und eine Dotierung von weniger als 5 * 10¹³/cm³ auf. Für Anwendungen bei niedrigen Blockierspannungen beträgt die Spannung weniger als 2000 V und die Driftschicht 2 weist typischerweise eine Dicke von weniger als 150 µm und eine Dotierung von mehr als 5 * 10¹³/cm³ auf.

In einer Ausführungsform weist die erste Stoppschicht 3 des Leistungshalbleiters 1 eine Dicke von (10 - 30) µm und / oder eine Dotierung von 10¹³ - 2 * 10¹⁵/cm³ im Bereich der Oberfläche auf. Mit einer solchen Auslegung der ersten Stoppschicht 3 kann das elektrische Feld im blockierenden Zustand abgebaut werden, bevor es in die Nähe der Elektrode 5 vordringt. Der Bereich zwischen dem Ende des elektrischen Feldes und der Elektrode 5 ist die Basis des IGBT-internen bipolaren Transistors. Durch eine derart ausgebildete erste Stoppschicht 3 wird dieser Bereich vergrössert und der Leck-Strom im blockierenden Zustand verringert. Mit einer derart niedrigen Dotierung kann aber gleichzeitig eine grosse SCSOA erzielt werden.

Die zweite Stoppschicht 4 weist eine Dicke von (1 - 10) µm und / oder eine Dotierung von 2 * 10¹⁵- 10¹⁷/cm³ im Bereich der Oberfläche auf. Mit einer solch hohen Dotierung kann die Elektroden-Injektionseffizienz bei niedriger Injektion der Elektrode 5 tief gehalten werden und es können somit niedrige Leck-Ströme im blockierenden Zustand erzielt werden. Mit einer solch geringen Dicke der zweiten Stoppschicht 4 wird die SCSOA nicht vermindert.

Die Elektrode 5 ist in einer Ausführungsform als transparente Elektrode ausgebildet. Diese wird durch ein Diffusionsverfahren erzeugt, wobei zuerst eine Implantation von Teilchen mit einer Dosis von (10¹³ - 10¹⁶)/cm² und nachfolgend eine Aktivierung vorgenommen wird. Die Dicke der Elektrode 5 beträgt weniger als 5 µm. Das Diffusionsverfahren wird im weiteren beschrieben.

Die Schichten eines Leistungshalbleiters 1 können durch ein Diffusionsverfahren und / oder epitaktisches Wachsen erzeugt werden. Zusätzlich können Schichten durch Bonding miteinander verbunden werden und durch Schneiden kann die Dicke einer Schicht reduziert werden. Die Verfahren werden im folgenden kurz erläutert.

Das Diffusionsverfahren wird durchgeführt, indem in eine Schicht, welche mit einem Ladungsträgertyp dotiert ist, Teilchen desselben oder eines anderen Ladungsträgertyps implantiert werden. In FIG 2 werden beispielsweise in einer niedrig dotierten Schicht 6 Teilchen zur Schaffung einer ersten Stoppschicht implantiert. Die implantierten Teilchen sind durch das Bezugszeichen 9 dargestellt. Anschliessend erfolgt eine Aktivierung, indem die implantierten Teilchen 9 in die niedrig dotierte Schicht 6 durch Erhitzen der Schicht bis zu einer vorgegebenen Tiefe 13 eindiffundiert werden. Das Diffundieren der implantierten Teilchen ist in FIG 2 durch die mit dem Bezugszeichen 12 versehenen Pfeile dargestellt. Je höher die Temperatur gewählt wird und je länger das Verfahren des Erhitzens durchgeführt wird, desto tiefer werden die Teilchen in die Schicht eingetrieben. Zur Schaffung einer ersten Stoppschicht 3 werden typischerweise Teilchen eines ersten Ladungsträgertyps 9 implantiert und bei langen Heizzeiten und hohen Temperaturen eingetrieben. Zur Schaffung einer zweiten Stoppschicht 4 werden Teilchen eines ersten Ladungsträgertyps implantiert und die implantierten Teilchen 10 typischerweise über eine kurze Zeit und eine niedrige Temperatur eingetrieben. Die Elektrode 5 wird durch Implantieren von Teilchen eines zweiten Ladungsträgertyps 11 und Diffundieren bei sehr kurzen Zeiten und niedrigen Temperaturen erzeugt.

Unter epitaktischem Wachsen versteht man ein Verfahren, bei welchem eine Halbleiterschicht in einer Gasumgebung hohen Temperaturen ausgesetzt wird. Auf der Oberfläche der Schicht scheiden sich Teilchen aus dem Gas ab, und es bildet sich eine Schicht.

Beim Bonding werden zwei Halbleiterschichten miteinander verbunden, indem sie hohen Temperaturen ausgesetzt werden. Es können Bindemittel zwischen den Schichten zur Verbesserung der Bindung verwendet werden.

Beim Schneiden einer Halbleiterschicht wird typischerweise die Dicke der Schicht durch Abschleifen, Polieren und / oder Ätzen reduziert.

In der folgenden Beschreibung wird nur eingegangen auf die Verfahrensschritte, mit denen die Stoppschichten 3, 4 des Leistungshalbleiters 1 geschaffen werden. Auf weitere Verfahrensschritte zur Herstellung eines Leistungshalbleiters 1, wie beispielsweise das Aufbringen von Metallisierungen oder Isolationen wird nicht eingegangen. Nach dem Aufbringen einer Metallisierung sollte der Leistungshalbleiter beispielsweise keinen hohen Temperaturen mehr ausgesetzt werden, durch welche die Metallisierung beschädigt würde. Daher sollten diese Verfahrensschritte zu einem derartigen Zeitpunkt durchgeführt werden, dass der Leistungshalbleiter bei folgenden Verfahrensschritten nicht mehr Bedingungen wie zu hohen Temperaturen ausgesetzt wird, die zur Beschädigung des Halbleiters führen. Alternativ können die Stoppschichten 3, 4 auch mit der Hilfe von schnell diffundierenden Dopanten erzeugt erden. Dadurch können diese beiden Schichten am Ende des Verfahrens bei niedrigen Temperaturen eindiffundiert werden.

Als elektrodenseitig wird die Seite einer Schicht bezeichnet, welche im fertigen Leistungshalbleiter 1 der Elektrode 5 zugewandt ist.

In FIG 2 ist ein Verfahren zur Herstellung eines Leistungshalbleiters 1 dargestellt, bei dem ausgehend von einer niedrig dotierten Schicht 6 eines ersten Ladungsträgertyps die Stoppschichten 3, 4 mittels Diffusionsverfahren erzeugt werden. Zur Bildung der ersten Stoppschicht 3 werden Teilchen des ersten Ladungsträgertyps 9 elektrodenseitig in eine niedrig dotierte Schicht 6 eines ersten Ladungsträgertyps implantiert und anschliessend bis zu einer vorgegebenen Tiefe 13 eingetrieben. Das Diffundieren von implantierten Teilchen in die Schicht ist in der Figur durch Pfeile mit dem Bezugszeichen 12 dargestellt. Dadurch wird eine mittel-dotierte Schicht 7 erzeugt. Der nunmehr verbleibende niedrig dotierte Teil der Schicht bildet die Driftschicht 2 im fertigen Leistungshalbleiter 1. Zur Bildung der zweiten Stoppschicht 4 werden anschliessend elektrodenseitig Teilchen des ersten Ladungsträgertyps 10 in die mittel-dotierte Schicht 7 implantiert und anschliessend bis zu einer vorgegebenen Tiefe 13 eingetrieben, wobei diese Tiefe geringer ist als die Tiefe, bis zu der die Teilchen 9 zur Bildung der ersten Stoppschicht 3 eingetrieben wurden. Durch dieses Eintreiben wird eine hoch dotierte Schicht 8 erzeugt. Der nunmehr verbleibende mittel-dotierte Teil der Schicht bildet die erste Stoppschicht 3 im fertigen Leistungshalbleiter 1. Vorteilhafterweise verwendet man bei der Herstellung des Leistungshalbleiters 1 eine dicke niedrig dotierte Schicht 6 des ersten Ladungsträgertyps, welche bei den einzelnen Schritten des Herstellungsverfahrens mechanische Robustheit bietet. Dieses Verfahren kann man deswegen mit Vorteil benutzen, um Leistungshalbleiter 1 für die Anwendung bei hohen Blockierspannungen herzustellen, da derartige Leistungshalbleiter 1 eine dicke Driftschicht 2 zur Aufnahme der hohen Spannungen aufweisen. Die mit diesem Verfahren hergestellten Leistungshalbleiter 1 können durch die zwei Diffusionsverfahren kostengünstig hergestellt werden. In einer Variante ist das in FIG 2 dargestellte Verfahren unter Verwendung von schnell diffundierenden Dopanten auch zur von Leistungshalbleitern 1 für den Einsatz bei niedrigen Blockierspannungen geeignet. Da solche Halbleiter 1 nur eine dünne Driftschicht 2 aufweisen, die keine mechanische Robustheit während des Herstellungsverfahrens bieten kann, wird von einer niedrig dotierten Schicht 6 eines ersten Ladungsträgertyps, die genügend dick ist, um mechanische Stabilität während des gesamten Herstellungsverfahrens zu gewährleisten, ausgegangen. Wenn die mechanische Stabilität der niedrig dotierten Schicht 6 für die weiteren Verfahrensschritte nicht mehr erforderlich ist, wird ein Teil der niedrig dotierten Schicht 6 elektrodenseitig abgeschnitten. Die Stoppschichten 3, 4 werden wie in FIG 2 dargestellt und oben beschrieben gebildet, wobei die Stoppschichten 3, 4 mittels schnell diffundierenden Dopanten bei niedrigen Temperaturen erzeugt werden. Der nunmehr verbleibende niedrig dotierte Teil der Schicht 6 bildet die Driftschicht 2 im fertigen Leistungshalbleiter 1. Die Stoppschichten 3, 4 werden deshalb mittels schnell diffundierenden Dopanten erzeugt, da diese keine hohen Temperaturen benötigen, um in die niedrig dotierte Schicht 6 einzudiffundieren. Die Stoppschichten 3, 4 können daher erzeugt werden, ohne dass man den fast fertigen Leistungshalbleiter 1 hohen Temperaturen aussetzen muss.

In FIG 3 ist ein Verfahren zur Herstellung eines Leistungshalbleiters 1 dargestellt, bei dem ausgehend von einer niedrig dotierten Schicht 6 die Stoppschichten 3, 4 mittels epitaktischen Wachsens erzeugt werden. Auf einer niedrig dotierten Schicht 6, welche im fertigen Leistungshalbleiter 1 der Driftschicht 2 entspricht, wird eine erste Stoppschicht 3 durch epitaktisches Wachsen erzeugt. Das epitaktische Wachsen ist in der Figur durch Pfeile mit dem Bezugszeichen 15 dargestellt. Anschliessend wird auf der ersten Stoppschicht 3 elektrodenseitig eine hoch dotierte Schicht 8 durch epitaktisches Wachsen zur Bildung der zweiten Stoppschicht 4 erzeugt. Bei diesem Herstellungsverfahren kann vorteilhafterweise eine dicke niedrig dotierte Schicht 6 verwendet werden, weil sie bei den einzelnen Schritten des Herstellungsverfahrens mechanische Robustheit bietet. Das Verfahren kann man deswegen mit Vorteil nutzen, um Leistungshalbleiter 1 für die Anwendung bei hohen Blockierspannungen herzustellen, da derartige Leistungshalbleiter 1 eine dicke Driftschicht 2 zur Aufnahme der hohen Spannungen benötigen. Die mit epitaktischem Wachsen erzeugten Stoppschichten 3, 4 weisen eine gleichmässige Dotierung über die gesamte Dicke bis einschliesslich der Grenzen der Schichten auf.

In FIG 4 ist ein Verfahren zur Herstellung eines Leistungshalbleiters 1 dargestellt, bei dem ausgehend von einer niedrig dotierten Schicht 6 die erste Stoppschicht 3 mittels Diffusionsverfahren und die zweite Stoppschicht 4 mittels epitaktischen Wachsens erzeugt werden. Auf einer niedrig dotierten Schicht 6, welche im fertigen Leistungshalbleiter 1 der Driftschicht 2 entspricht, wird eine mittel-dotierte Schicht 7 durch epitaktisches Wachsen 15 erzeugt. Zur Bildung der zweiten Stoppschicht 4 werden anschliessend elektrodenseitig Teilchen des ersten Ladungsträgertyps 10 in die mittel-dotierte Schicht 7 implantiert und anschliessend bis zu einer vorgegebenen Tiefe 13 eingetrieben, wobei diese Tiefe 13 geringer ist als die Dicke der mittel-dotierten Schicht 7. Durch dieses Eintreiben wird eine hoch dotierte Schicht 8 erzeugt. Der nunmehr verbleibende mittel-dotierte Teil der Schicht bildet die erste Stoppschicht 3 im fertigen Leistungshalbleiter 1. Bei diesem Herstellungsverfahren kann vorteilhafterweise eine dicke niedrig dotierte Schicht 6 verwendet werden, weil sie bei den einzelnen Schritten des Herstellungsverfahrens mechanische Robustheit bietet. Das Verfahren kann man deswegen mit Vorteil nutzen, um Leistungshalbleiter 1 für die Anwendung bei hohen Blockierspannungen herzustellen, da derartige Leistungshalbleiter 1 eine dicke Driftschicht 2 zur Aufnahme der hohen Spannungen benötigen. Die mittels epitaktischen Wachsens erzeugte zweite Stoppschicht 4 weist eine gleichmässige Dotierung über die gesamte Dicke bis einschliesslich der Grenzen der Schicht auf.

In FIG 5 ist ein Verfahren zur Herstellung eines Leistungshalbleiters 1 dargestellt, bei dem ausgehend von einer hoch dotierten Schicht 8 eine erste Stoppschicht 3 und eine Driftschicht 2 mittels epitaktischen Wachsens erzeugt werden. Auf einer hoch dotierten Schicht 8 wird eine erste Stoppschicht 3 durch epitaktisches Wachsen erzeugt. Das epitaktische Wachsen ist in der Figur durch Pfeile mit dem Bezugszeichen 15 dargestellt. Anschliessend wird auf der ersten Stoppschicht 3 auf der der Elektrode 5 abgewandten Seite eine niedrig dotierte Driftschicht 2 durch epitaktisches Wachsen 15 erzeugt. Am Ende des Verfahrens wird ein Teil der hoch dotierten Schicht 8 elektrodenseitig bis auf den für die Anwendung gewünschten Endbereich abgeschnitten, da die durch eine anfangs dickere Schicht 8 erreichte mechanische Stabilität nun nicht mehr erforderlich ist. Dies ist in der Figur durch eine gestrichelte Linie mit dem Bezugszeichen 14 dargestellt. Vorteilhafterweise verwendet man bei der Herstellung des Leistungshalbleiters 1 eine dicke hoch dotierte Schicht 8 des ersten Ladungsträgertyps, welche bei den einzelnen Schritten des Herstellungsverfahrens mechanische Robustheit bietet. Dieses Verfahren eignet sich besonders um Leistungshalbleiter 1 zur Anwendung bei niedrigen Blockierspannungen herzustellen, weil bei solchen Anwendungen die nach diesem Verfahren epitaktisch hergestellte Driftschicht 2 und die erste Stoppschicht 3 relativ dünn sind, womit die Erzeugung dieser beider Schichten wirtschaftlich noch vertretbar ist.

In FIG 6 ist ein Verfahren zur Herstellung eines Leistungshalbleiters 1 dargestellt, bei dem ausgehend von einer mittel-dotierten Schicht 7 eine Driftschicht 2 mittels epitaktischen Wachsens und eine zweite Stoppschicht 4 mittels Diffusionsverfahren erzeugt werden. Auf einer mittel-dotierten Schicht 7 wird eine Driftschicht 2 auf der Seite, die von der Elektrodenseite abgewandt ist, durch epitaktisches Wachsen erzeugt. Ein Teil der mittel-dotierten Schicht 7 wird dann elektrodenseitig abgeschnitten. Zur Bildung der zweiten Stoppschicht 4 werden anschliessend elektrodenseitig Teilchen des ersten Ladungsträgertyps 10 in die mittel-dotierte Schicht 7 bis zu einer vorgegebenen Tiefe 13 eingetrieben, wobei diese Tiefe geringer ist als die Dicke der mittel-dotierten Schicht 7. Durch dieses Eintreiben wird eine hoch dotierte Schicht 8 erzeugt. Der nunmehr verbleibende mittel-dotierte Teil der Schicht bildet die erste Stoppschicht 3 im fertigen Leistungshalbleiter 1. Dieses Verfahren eignet sich besonders um Leistungshalbleiter 1 zur Anwendung bei niedrigen Blockierspannungen herzustellen, weil bei solchen Anwendungen die nach diesem Verfahren epitaktisch hergestellte Driftschicht 2 eine Dicke von weniger als 150 µm aufweist, womit die Erzeugung dieser Schicht wirtschaftlich noch vertretbar ist.

In FIG 7 ist ein Verfahren zur Herstellung eines Leistungshalbleiters 1 dargestellt, bei dem ausgehend von einer hoch dotierten Schicht 8 und einer niedrig dotierten Schicht 6 eine erste Stoppschicht 3 mittels epitaktischen Wachsens erzeugt wird. Auf der niedrig dotierten Schicht 6 wird eine erste Stoppschicht 3 elektrodenseitig durch epitaktisches Wachsen erzeugt. Anschliessend werden beide Schichten 6, 8 durch Bonding 16 miteinander verbunden, wobei die erste Stoppschicht 3 zwischen der niedrig dotierten Schicht 6 und der hoch dotierten Schicht 8 eingebettet wird. Ein Teil der niedrig dotierten Schicht 6 wird auf der Seite, die von der Elektrodenseite abgewandt ist, abgeschnitten, und der verbleibende niedrig dotierte Bereich der Schicht bildet die Driftschicht 2. Am Ende des Verfahrens wird ein Teil der hoch dotierten Schicht 8 elektrodenseitig abgeschnitten, da die mechanische Stabilität nicht mehr erforderlich ist. Vorteilhafterweise verwendet man eine dicke hoch dotierte Schicht 8, welche genügend mechanische Stabilität bei den Schritten des Herstellungsverfahrens des Leistungshalbleiter 1 bietet. Dieses Verfahren eignet sich besonders für die Herstellung von Leistungshalbleiter 1 zur Anwendung bei niedrigen Blockierspannungen.

In FIG 8 ist ein Verfahren zur Herstellung eines Leistungshalbleiters 1 dargestellt, bei dem ausgehend von einer hoch dotierten Schicht 8 und einer niedrig dotierten Schicht 6 eine erste Stoppschicht 3 mittels Diffusionsverfahren erzeugt wird. Zur Bildung der ersten Stoppschicht 3 werden Teilchen des ersten Ladungsträgertyps 9 elektrodenseitig in die niedrig dotierte Schicht 6 eines ersten Ladungsträgertyps implantiert und anschliessend bis zu einer vorgegebenen Tiefe 13 eingetrieben. Das Diffundieren von implantierten Teilchen in die Schicht ist in FIG 8 durch Pfeile mit dem Bezugszeichen 12 dargestellt. Dadurch wird eine erste Stoppschicht 3, welche mittel-dotiert ist, erzeugt. Anschliessend werden beide Schichten 6, 8 durch Bonding 16 miteinander verbunden, wobei die erste Stoppschicht 3 zwischen der niedrig dotierten Schicht 6 und der hoch dotierten Schicht 8 eingebettet wird. Ein Teil der niedrig dotierten Schicht 6 wird auf der Seite, die von der Elektrodenseite abgewandt ist, abgeschnitten, und der verbleibende niedrig dotierte Bereich der Schicht bildet die Driftschicht 2. Am Ende des Verfahrens wird ein teil der hoch dotierten Schicht 8 elektrodenseitig abgeschnitten, da die mechanische Stabilität nicht mehr erforderlich ist. Vorteilhafterweise verwendet man eine dicke hoch dotierte Schicht 8 welche, genügend mechanische Stabilität bei den Schritten des Herstellungsverfahrens des Leistungshalbleiter 1 bietet.

In FIG 9 ist ein Verfahren zur Herstellung eines Leistungshalbleiters 1 dargestellt, bei dem ausgehend von einer hoch dotierten Schicht 8 und einer niedrig dotierten Schicht 6 eine erste Stoppschicht 3 mittels epitaktischen Wachsens erzeugt wird. Auf der hoch dotierten Schicht 8 wird eine erste Stoppschicht 3 auf der Seite, die der Elektrodenseite abgewandt ist, durch epitaktisches Wachsen erzeugt. Anschliessend werden die beiden Schichten 6 und 8 durch Bonding 16 miteinander verbunden, wobei die erste Stoppschicht 3 zwischen der niedrig dotierten Schicht 6 und der hoch dotierten Schicht 8 eingebettet wird. Die niedrig dotierte Schicht 6 wird auf der Seite, die von der Elektrodenseite abgewandt ist, abgeschnitten, und der verbleibende niedrig dotierte Bereich der Schicht bildet die Driftschicht 2. Am Ende des Verfahrens wird ein Teil der hoch dotierten Schicht 8 elektrodenseitig abgeschnitten. Dieses Verfahren eignet sich besonders für die Herstellung von Leistungshalbleiter 1 zur Anwendung bei niedrigen Blockierspannungen. Vorteilhafterweise verwendet man bei der Herstellung des Leistungshalbleiters 1 eine dicke niedrig dotierte Schicht 6 und eine dicke hoch dotierte Schicht 8 des ersten Ladungsträgertyps, welche bei den einzelnen Schritten des Herstellungsverfahrens mechanische Robustheit bieten.

In FIG 10 wird von dem Endprodukt aus den Herstellungsverfahren nach einer der Figuren FIG 2 bis 9 ausgegangen. Dabei ist auf einer niedrig dotierten Driftschicht 2 eines ersten Ladungsträgertyps eine höher dotierte erste Stoppschicht 3 des ersten Ladungsträgertyps angeordnet, auf der wiederum eine hoch dotierte Schicht 8 des ersten Ladungsträgertyps angeordnet ist. Zur Bildung der Elektrode 5 werden Teilchen des zweiten Ladungsträgertyps 11 in die hoch dotierte Schicht 8 elektrodenseitig bis zu einer vorgegebenen Tiefe 13 diffundiert. Der nunmehr verbleibende hoch dotierte Teil der Schicht des ersten Ladungsträgertyps bildet die zweite Stoppschicht 4 im fertigen Leistungshalbleiter 1.

### Bezugszeichenliste

- 1: Leistungshalbleiter
- 2: Driftschicht
- 3: erste Stoppschicht
- 4: zweite Stoppschicht
- 5: Elektrode
- 6: niedrig dotierte Schicht
- 7: mittel-dotierte Schicht
- 8: hoch dotierte Schicht
- 9: Teilchen zur Schaffung einer ersten Stoppschicht
- 10: Teilchen zur Schaffung einer zweiten Stoppschicht
- 11: Teilchen zur Schaffung einer Elektrode
- 12: Diffundieren von implantierten Teilchen
- 13: Tiefe, bis zu der Teilchen in die Schicht eingetrieben werden
- 14: Schnitt durch Halbleiterschicht
- 15: epitaktisches Wachsen
- 16: Bonding

## Patentansprüche

1. Leistungshalbleiter (1), insbesondere ein IGBT mit einer Driftschicht (2) mit einer Dotierung eines ersten Ladungsträgertyps und
einer ersten Stoppschicht (3) mit einer Dotierung desselben Ladungsträgertyps wie die Driftschicht (2), wobei die Dotierung der ersten Stoppschicht (3) höher ist als die Dotierung der Driftschicht (2),
und einer Elektrode (5) eines zweiten Ladungsträgertyps,
**dadurch gekennzeichnet, dass**
zwischen der ersten Stoppschicht (3) und der Elektrode (5) eine zweite Stoppschicht (4) mit einer Dotierung des ersten Ladungsträgertyps angeordnet ist und dass die zweite Stoppschicht (4) eine höhere Dotierung als die erste Stoppschicht (3) aufweist.

2. Leistungshalbleiter nach Anspruch 1,
**dadurch gekennzeichnet, dass**
die erste Stoppschicht (3) eine Dicke von 10 - 30 µm und / oder eine Dotierung von (10¹³ - 2*10¹⁵)/cm³ im Bereich der Oberfläche aufweist.

3. Leistungshalbleiter nach Anspruch 1,
**dadurch gekennzeichnet, dass**
die zweite Stoppschicht (4) eine Dicke von 1 - 10 µm und /oder eine Dotierung von (2*10¹⁵ -10¹⁷)/cm³ im Bereich der Oberfläche aufweist.

4. Verfahren zur Herstellung eines Leistungshalbleiters (1), umfassend eine Driftschicht (2) mit einer Dotierung eines ersten Ladungsträgertyps,
eine erste Stoppschicht (3) mit einer Dotierung des ersten Ladungsträgertyps und
eine Elektrode (5) eines zweiten Ladungsträgertyps,
wobei die Dotierung der ersten Stoppschicht (3) höher ist als die Dotierung der Driftschicht (2);
bei welchem Verfahren zur Herstellung des Leistungshalbleiters (1) zuerst die Schichten des ersten Ladungsträgertyps geschaffen werden und danach die Elektrode (5) in diejenige Schicht des ersten Ladungsträgertyps, welche die höchste Dotierung der Schichten des ersten Ladungsträgertyps aufweist, eindiffundiert wird,
**dadurch gekennzeichnet, dass**
eine zweite, im fertiggestellten Leistungshalbleiter (1) zwischen der ersten Stoppschicht (3) und der Elektrode (5) angeordnete Stoppschicht (4) des ersten Ladungsträgertyps mit einer Dotierung, welche höher ist als die Dotierung der ersten Stoppschicht (3), erzeugt wird.

5. Verfahren nach Anspruch 4,
**dadurch gekennzeichnet, dass**
zum Erzeugen der zweiten Stoppschicht (4) in eine Schicht (6) mit einer Dotierung des ersten Ladungsträgertyps eine erste Stoppschicht (3) des ersten Ladungsträgertyps eindiffundiert wird, in die erste Stoppschicht (3) eine zweite Stoppschicht (4) eindiffundiert wird und in die zweite Stoppschicht (4) eine Schicht des zweiten Ladungsträgertyps als Elektrode (5) eindiffundiert wird.

6. Verfahren nach Anspruch 4 oder 5,
**dadurch gekennzeichnet, dass**
zum Erzeugen der zweiten Stoppschicht (4) mindestens eine der Schichten des ersten Ladungsträgertyps durch epitaktisches Wachsen (15) erzeugt wird.

7. Verfahren nach einem der Ansprüche 4 bis 6,
**dadurch gekennzeichnet, dass**
zum Erzeugen der zweiten Stoppschicht (4) mindestens zwei der Schichten des ersten Ladungsträgertyps durch Bonding (16) miteinander verbunden werden.

8. Verfahren nach einem der Ansprüche 4 bis 7,
**dadurch gekennzeichnet, dass**
zum Erzeugen der zweiten Stoppschicht (4) mindestens eine der Schichten des ersten Ladungsträgertyps ausgedünnt (14) wird.
